# FASCICULE DE BREVET EUROPEEN

(11) **EP 1 418 673 B1**
(45) Date de publication et mention de la délivrance du brevet: **07.11.2007**
(21) Numéro de dépôt: 03292801.2
(22) Date de dépôt: 07.11.2003
(51) Int. Cl.: H03K 17/96

(54) **Retour tactile pour switch sensitif**
Taktile Rückmeldung für Berührungsschalter
Tactile feedback for touch switch

(30) Priorité: 08.11.2002 FR 0214152
(43) Date de publication de la demande: 12.05.2004
(73) Titulaire: Delphi Technologies Inc., Troy, Michigan 48007 (US)
(72) Inventeur: Kayser, Hervé, 67640 Fegersheim (FR); Stricker, Jean-Mathieu, 67610 La Wantzenau (FR); Hell, Catherine, 68480 Sonnersdorf (FR)
(74) Mandataire: Merckling, Norbert

(56) Documents cités:
- DE-A- 10 103 563
- US-A- 5 982 304

## Description

La présente invention se rapporte au domaine technique et général des commutateurs utilisés dans diverses applications. Ces commutateurs sont notamment destinés à mettre en oeuvre ou à actionner des fonctions de commande ou à enregistrer des consignes par exemple dans le domaine de l'automobile.

Dans ce secteur d'activité, on connaît des commutateurs qui sont en majorité mécaniques, c'est-à-dire qu'une pièce en mouvement vient réaliser un contact électrique validant une fonction correspondante. Ce genre de commutateurs de commande présente en général une certaine course d'actionnement qu'il est possible d'atteindre en exerçant un effort adéquat. Une telle course, une fois parcourue, permet à l'utilisateur d'avoir un retour d'information, du type sensitif, sur la fonction commandée. Ces commutateurs présentent cependant un encombrement non négligeable qui est susceptible de nuire à leur esthétique.

En outre, les pièces mécaniques utilisées sont en général nombreuses et posent des problèmes d'étanchéité dans leur assemblage, ce qui réduit substantiellement leur durée de vie. Il est évident que de tels commutateurs présentent ou génèrent un coût non négligeable.

On connaît aussi des commutateurs capacitifs. Ces derniers présentent l'avantage de ne pas avoir de pièces mécaniques en mouvement et donnent une grande liberté au niveau de l'esthétique. Ils présentent par ailleurs un encombrement réduit, une bonne étanchéité et par conséquent une durée de vie plus longue pour un coût moindre étant donné la diminution du nombre de pièces constitutives. Les commutateurs capacitifs présentent cependant un inconvénient majeur, lié au fait qu'ils ne procurent pas de retour d'information à l'utilisateur.

D'autres axes techniques tels qu'un retour d'information par voie sonore ou visuelle, risquent de perturber l'utilisateur en particulier quand il s'agit d'un conducteur de véhicule ou tout simplement de ne pas être transmis et compris par l'utilisateur. Ceci est le cas notamment pour un système sonore qui serait perturbé par l'environnement du conducteur. Par ailleurs un retour d'information visuel obligerait le conducteur à visualiser ledit commutateur pour recevoir un tel retour d'information et détourner ses yeux de la route.

Il est connu de réaliser un commutateur électrique du type à détection d'actionnement résultant d'un contact de l'utilisateur, sans qu'il y ait déplacement d'aucun organe mécanique appartenant audit commutateur, lequel comporte des moyens pour générer un retour d'information d'ordre tactile signalant audit utilisateur que la détection a été faite et la commutation réalisée, les moyens pour générer un retour d'information d'ordre tactile, lorsque la détection est effective, provoquant un mouvement impulsionnel ou vibratoire d'un élément mécanique au contact du doigt actionneur de l'utilisateur.

On connaît ainsi, par l'intermédiaire du document US - 5 982 304, un commutateur électrique du type à détection d'actionnement, résultant d'un contact de l'utilisateur, sans qu'il y ait déplacement d'un organe mécanique appartenant audit commutateur.

Ce dernier comporte des moyens pour générer un retour d'informations d'ordre tactile, signalant audit utilisateur que la détection a été faite et la commutation réalisée.

Les moyens pour générer un retour d'informations d'ordre tactile, lorsque la détection est effective, provoquent la mise en mouvement impulsionnel d'un élément mécanique au contact du doigt actionneur de l'utilisateur.

Le mouvement impulsionnel est obtenu par l'intermédiaire notamment d'un élément piézoélectrique générant des impulsions de faible amplitude. Ainsi, lors de l'utilisation du véhicule, lorsque ce dernier se déplace, le mouvement impulsionnel peut ne pas être perçu ou masqué par des vibrations liées audit déplacement. De la même manière, des mouvements impulsionnels de faible amplitude ne peuvent que très difficilement être perçus lorsque l'utilisateur du véhicule utilise des gants.

Le document DE - 101 03563 se rapporte à un dispositif permettant l'alimentation en données de fonctionnement d'une unité de commande d'un appareil domestique (du type machine à laver).

Le document décrit un commutateur électrique du type à détection d'actionnement résultant d'un contact de l'utilisateur sans qu'il y ait déplacement d'un organe mécanique appartenant audit commutateur. Ce dernier comporte des moyens pour générer un retour d'informations d'ordre tactile signalant audit utilisateur que la détection a été faite et la commutation réalisée.

Les moyens pour générer un retour d'informations d'ordre tactile provoquent la mise en mouvement répétitive d'un élément mécanique au contact du doigt de l'actionneur.

Ce document ne prévoit qu'une détection en fonction de la force d'actionnement initial et une comparaison à une valeur seuil en deçà de laquelle la commutation n'est pas effectuée et aucun signal de retour d'informations n'est émis, hormis le cas échéant un signal d'information permettant à l'utilisateur d'identifier un dysfonctionnement.

Dans une telle application, l'utilisation d'un élément piézoélectrique présente l'inconvénient d'avoir un seuil de détection d'efforts relativement bas, lequel est difficilement quantifiable et perceptible par l'utilisateur.

En outre, la perception est variable d'un utilisateur à l'autre.

Le but de la présente invention vise à s'affranchir des inconvénients de l'état de la technique d'une part et à réaliser un commutateur susceptible de générer un retour d'information à l'utilisateur sans pour autant incorporer des pièces mécaniques en déplacement relatif.

Un autre but de la présente invention vise à s'affranchir de toute détection d'efforts pour générer un retour d'information d'ordre tactile, c'est-à-dire d'utiliser une détection de présence seule pour générer ledit signal de retour d'information.

Selon l'invention, les moyens générant un retour d'information tactile sont alimentés par un signal électrique, émis lorsque la détection du contact est effective, et mis en forme et/ou modulé par un circuit électronique de contrôle, la détection étant réalisée grâce à un détecteur capacitif relié au circuit électronique de contrôle.

Selon un exemple de réalisation, les moyens pour générer un retour d'information d'ordre tactile, provoquent la mise en mouvement répétitive d'un élément mécanique au contact du doigt actionneur.

L'utilisateur est donc informé instantanément de l'actionnement d'une fonction.

Les moyens pour générer un retour d'information d'ordre tactile, lorsque la détection est effective, provoquent par exemple la mise en mouvement répétitive d'un élément mécanique au contact du doigt actionneur. La détection est effective avant même que l'utilisateur n'enlève son doigt de la touche tactile.

Selon un autre mode de réalisation du commutateur conforme à l'invention, les moyens pour générer un retour d'information d'ordre tactile, lorsque la détection est effective, provoquent la mise en mouvement variable d'un élément mécanique au contact du doigt actionneur en fonction de la durée, de l'amplitude ou de la force d'actionnement initiale. L'utilisateur sait par conséquent jusqu'à quel niveau ou degré la fonction commandée a été mise en oeuvre.

Selon un exemple de réalisation, les moyens pour générer un retour d'information tactile comportent un moteur électrique, entraînant en rotation une masselotte dont le centre de gravité est excentré radialement par rapport à son axe de rotation.

Selon un autre mode de réalisation du commutateur conforme à l'invention, les moyens pour générer un retour d'information d'ordre tactile provoquent une vibration en réponse à la détection du contact effectué par l'utilisateur.

La vibration est par exemple obtenue par un composant piézoélectrique dont la vibration mécanique est provoquée par l'alimentation d'au moins une électrode avec un signal électrique émis après détection du contact de l'utilisateur. Un tel composant présente l'avantage d'une grande compacité et par conséquent d'une bonne intégration dans toute forme sans nuire à l'esthétique de l'ensemble.

Le signal d'alimentation est avantageusement généré par un circuit électronique de contrôle de la détection.

La détection du contact de l'utilisateur est réalisée par exemple au moyen d'un détecteur capacitif.

Selon un mode de réalisation du commutateur conforme à l'invention, une électrode du composant piézoélectrique peut servir d'antenne au détecteur capacitif.

Le composant piézoélectrique est alors commuté d'un mode antenne à un mode vibratile via un organe de commutation du type relais, multiplexeur ou équivalent.

Le signal d'alimentation du composant piézoélectrique est un signal d'allure sinusoïdal, émis à une fréquence comprise de préférence entre 220 Hz et 300 Hz.

Le signal d'alimentation peut être modulé en amplitude par un signal sinusoïdal de basse fréquence.

Selon un mode de réalisation du commutateur conforme à l'invention, le signal sinusoïdal est envoyé par salves régulières.

D'autres caractéristiques et avantages ressortiront également de la description détaillée figurant ci-après, en référence aux dessins annexés à titre d'exemples non limitatifs dans lesquels :
- la figure 1 est un schéma de principe du commutateur conforme à l'invention,
- la figure 2 présente un logigramme de fonctionnement du commutateur conforme à l'invention, dans lequel une électrode d'un composant piézoélectrique sert d'antenne,
- la figure 3 est un exemple de réalisation d'un commutateur conforme à l'invention, et
- la figure 4 est une représentation schématique de blocs fonctionnels des différentes étapes de fonctionnement d'un commutateur conforme à l'invention.
- la figure 5 est un logigramme représentant un autre mode de fonctionnement d'un commutateur conforme à l'invention,
- la figure 6 est une représentation partielle d'un autre exemple de réalisation d'un commutateur conforme à l'invention.

Le commutateur 1 conforme à l'invention comprend un composant ou une pastille piézoélectrique 2 comportant un élément céramique piézoélectrique et une électrode métallique 3 assemblés de façon intime par tout moyen connu, par exemple par collage.

Le commutateur 1 comprend également un détecteur capacitif 4 relié électriquement à l'électrode métallique 3. Un circuit électronique de contrôle 5 permet d'analyser le signal issu du détecteur capacitif 4. Le circuit de contrôle électronique 5 est également relié à des moyens de génération d'un signal 6, lesquels permettent d'actionner ou d'activer via le signal transmis, la pastille piézoélectrique 2.

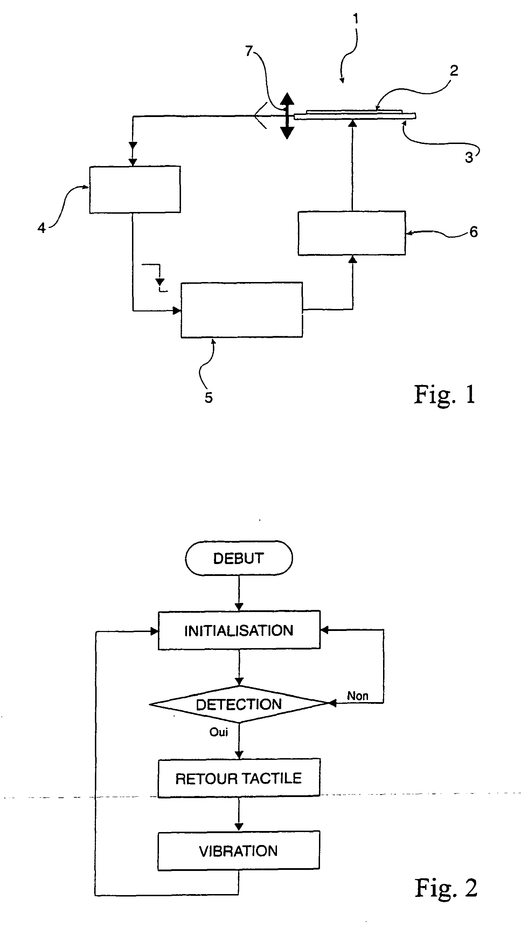

Les vibrations générées par la pastille piézoélectrique 2 sont schématisées par la flèche 7. Le retour d'information d'ordre tactile est ainsi matérialisé par la pastille piézoélectrique 2 que l'on va faire vibrer après une détection du capteur capacitif 4. L'électrode métallique 3 sert ainsi également d'antenne pour le détecteur capacitif. L'électrode métallique 3 bascule ainsi entre un mode antenne et un mode vibratile, tel que cela est schématisé à la figure 2. Le circuit électronique de contrôle 5 comprend par exemple un microcontrôleur permettant de générer différentes informations liées d'une part à la détection du capteur capacitif 4 et d'autre part à la nature du signal de retour qu'il convient de transmettre à l'utilisateur par l'intermédiaire de la pastille piézoélectrique 1.

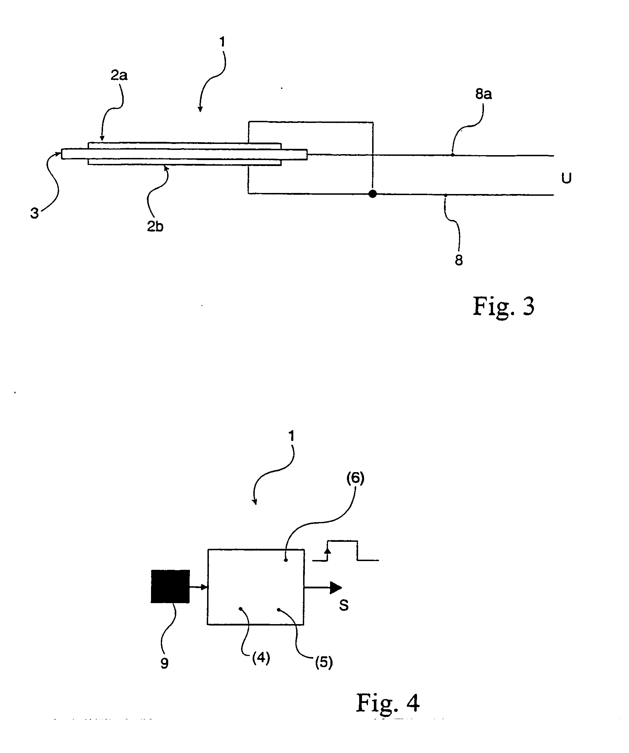

L'électrode métallique 3 est de préférence souple. Selon un autre mode de réalisation conforme à l'invention représenté à la figure 3, la pastille piézoélectrique 1 peut comporter une électrode métallique 3 et deux éléments céramiques 2a, 2b disposés de part et d'autre de ladite électrode métallique 3. Chacun des éléments céramiques 2a, 2b est mis au même potentiel électrique via un premier conducteur 8, un second conducteur 8a mettant l'électrode métallique 3 à un second potentiel électrique. Les deux éléments céramiques 2a, 2b sont également disposés de façon que leur polarisation soit dirigée dans un même sens. Leurs déplacements sous l'effet des vibrations, se font alors dans un même sens. La prise en sandwich de l'électrode métallique 3 entre deux éléments céramiques 2a, 2b permet ainsi d'amplifier les vibrations.

Le détecteur capacitif 4 dont le fonctionnement est schématisé par exemple à la figure 4, permet de détecter la présence d'un doigt appelé doigt actionneur sur une touche 9 incluant la pastille piézoélectrique 2, afin de réaliser la fonction de commutation et ce en mesurant une variation de capacité. Le capteur capacitif 4 fournit une impulsion de durée fixe en sortie S. Cette impulsion est transmise au circuit électronique de contrôle 5.

Le logigramme représenté à la figure 2 montre schématiquement le fonctionnement du commutateur 1 conforme à l'invention. Un début de fonctionnement est atteint lorsque l'utilisateur actionne par exemple une clé de contact de façon à initialiser le commutateur 1, par conséquent à initialiser le mode de détection de cette dernière.

Ensuite, lorsque le capteur capacitif 4 détecte la présence d'un doigt sur la touche 9, il bascule du mode détection vers un mode vibratile et le circuit électronique de contrôle 5 et les moyens de génération d'un signal de retour tactile 6 génèrent un signal qui provoque les vibrations de la pastille piézoélectrique 2. L'amplitude des vibrations et/ou leur durée sont adaptées à la durée d'actionnement de la touche 9.

Lorsque le capteur capacitif 4 ne détecte aucune présence de doigt sur la touche 9, la pastille piézoélectrique 2 reste dans un mode de détection et d'initialisation. Ainsi lorsque le capteur capacitif 4 aura détecté une variation de capacité à l'approche du doigt de l'utilisateur, la pastille piézoélectrique 2 basculera en mode "retour tactile" via un relais ou un autre commutateur du type multiplexeur, non représenté, et entrera en vibration pendant une certaine durée. Cette vibration sert ainsi de retour tactile sur le doigt de l'utilisateur. L'électrode métallique 3 sert donc d'antenne.

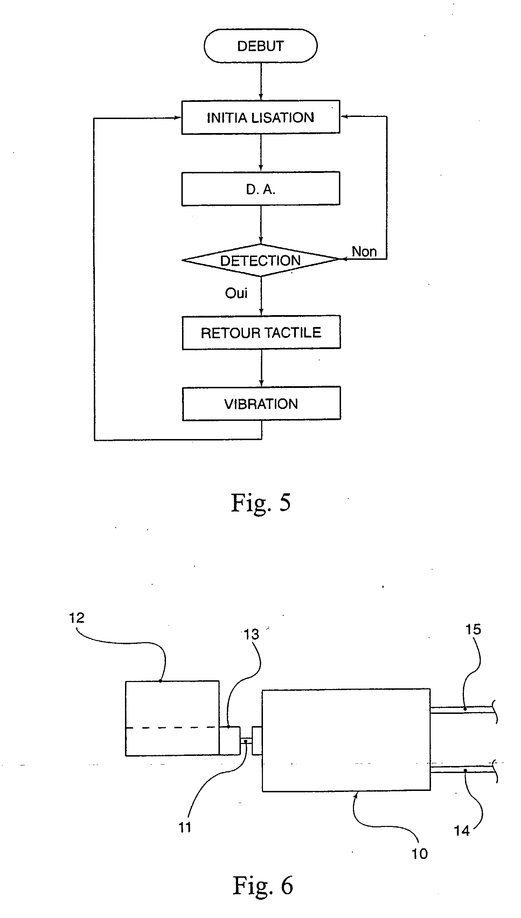

La figure 5 montre un autre exemple de fonctionnement d'un commutateur 1, dans lequel l'électrode métallique 3 ne sert pas d'antenne au détecteur capacitif 2. La détection et le retour tactile se font ainsi par l'intermédiaire de moyens différentiés. Le mode détection sera toujours activé, et schématisé par le bloc (D.A.) à la figure 5. Il n'est plus nécessaire de faire basculer l'électrode métallique 3 entre un mode détection et un mode vibratile.

Le signal de base générant la vibration de la pastille piézoélectrique 2 est de préférence un signal sinusoïdal de fréquence comprise entre 220 et 300 Hz. L'avantage de ce signal est qu'il ne génère pas de sons contrairement aux signaux carrés ou triangulaires qui sont riches en harmonie. De plus, il faut noter que c'est autour d'une fréquence de 250 Hz que les corpuscules de Pacini qui sont des récepteurs cutanés mécaniques humains sont le plus sensibles aux vibrations.

Le signal de base pourra être le cas échéant légèrement modifié afin d'augmenter la perception de la vibration, notamment en combinant le signal de base d'environ 250 Hz à un signal de basse fréquence. Le signal basse fréquence, par exemple sinusoïdal, peut présenter par exemple une fréquence comprise entre 10 Hz et 20 Hz. On peut ainsi moduler le signal en amplitude ou générer des salves de sinus. Ces signaux de base modifiés offrent généralement une sensation plus perceptible et plus agréable qu'un simple de vibration purement sinusoïdal.

Ces différents signaux pourront par exemple être générés à l'aide d'un oscillateur à quartz, d'un convertisseur digital/analogique par un montage sommateur ou par un composant programmable intégrant un mode de modulation de largeur d'impulsion suivi d'un intégrateur.

L'avantage d'un commutateur 1 conforme à l'invention réside dans sa très grande adaptabilité. On peut ainsi, sur une console centrale, prévoir que chaque touche délivre un signal de retour tactile différent. On peut également faire varier la fréquence du signal, la forme du signal modulé ou la fréquence du signal modulé. L'utilisation peut ainsi associer un type de retour tactile, correspondant à une perception donnée, à une fonction déterminée.

Les commutateurs 1 comportant une pastille piézoélectrique 2 permettent par ailleurs de réduire substantiellement leur encombrement. Ils présentent également des temps de réponse très courts, de l'ordre de la milliseconde, et leur consommation d'énergie électrique est faible.

Selon un exemple de réalisation, représenté en partie à la figure 6, le moyen pour générer un retour d'information d'ordre tactile comporte un moteur 10, entraînant en rotation un axe 11. Ce dernier est associé à une masselotte 12 monté sur l'axe 11 par tous moyens et notamment par l'intermédiaire d'une bague cylindrique 13 de fixation.

La masselotte 12 présente une forme en demi-cylindre ou en cylindre tronqué, de manière à présenter un centre de gravité décentré radialement par rapport à l'axe 11.

Lors de la rotation de l'axe 11 on obtient ainsi une vibration dont la fréquence dépend de la vitesse de rotation dudit axe 11.

Le moteur est associé à des moyens d'alimentation électrique 14, 15 et l'alimentation dudit moteur 10 est avantageusement pilotée par le circuit électrique de contrôle 5 de la détection.

## Revendications

1. Commutateur (1) électrique du type à détection d'actionnement résultant d'un contact de l'utilisateur, sans qu'il y ait déplacement d'aucun organe mécanique appartenant audit commutateur, lequel comporte des moyens pour générer un retour d'information d'ordre tactile signalant audit utilisateur que la détection a été faite et la commutation réalisée, les moyens pour générer un retour d'information d'ordre tactile, lorsque la détection est effective, provoquant un mouvement impulsionnel ou vibratoire d'un élément mécanique au contact du doigt actionneur de l'utilisateur, **caractérisé en ce que** les moyens générant un retour d'information tactile sont alimentés par un signal électrique, émis lorsque la détection du contact est effective, et mis en forme et/ou modulé par un circuit électronique de contrôle (5), la détection étant réalisée grâce à un détecteur capacitif relié au circuit électronique de contrôle (5).

2. Commutateur (1) électrique selon la revendication 1, **caractérisé en ce que** les moyens pour générer un retour d'information d'ordre tactile, provoquent la mise en mouvement répétitive d'un élément mécanique au contact du doigt actionneur.

3. Commutateur (1) électrique selon la revendication 1, **caractérisé en ce que** les moyens pour générer un retour d'information d'ordre tactile, provoquent la mise en mouvement variable d'un élément mécanique au contact du doigt actionneur en fonction de la durée, de l'amplitude ou de la force d'actionnement initiale.

4. Commutateur (1) électrique selon l'une quelconque des revendications 1 à 3, **caractérisé en ce que** les moyens pour générer un retour d'information tactile comportent un moteur électrique, entraînant en rotation une masselotte dont le centre de gravité est excentré radialement par rapport à son axe de rotation.

5. Commutateur (1) électrique selon la revendication 1, **caractérisé en ce que** les moyens pour générer un retour d'information d'ordre tactile provoquent une vibration en réponse à la détection du contact effectué par l'utilisateur.

6. Commutateur (1) électrique selon la revendication précédente, **caractérisé en ce que** la vibration est obtenue par un composant piézoélectrique (2) dont la vibration mécanique est provoquée par l'alimentation d'au moins une électrode (3), avec un signal électrique émis après détection du contact de l'utilisateur.

7. Commutateur (1) électrique selon la revendication précédente, **caractérisé en ce qu'**au moins une électrode (3) du composant piézoélectrique (2) sert d'antenne au détecteur capacitif (4).

8. Commutateur (1) électrique selon la revendication précédente, **caractérisé en ce que** le composant piézoélectrique (2) est commuté d'un mode antenne à un mode vibratile via un organe de commutation du type relais, multiplexeur ou équivalent.

9. Commutateur (1) électrique selon l'une des revendications 6 à 8, **caractérisé en ce que** le signal d'alimentation du composant piézoélectrique (2) est un signal d'allure sinusoïdale, émis à une fréquence comprise entre 220 Hz et 300 Hz.

10. Commutateur (1) électrique selon la revendication précédente, **caractérisé en ce que** ledit signal est modulé en amplitude par un signal sinusoïdal de basse fréquence.

11. Commutateur (1) électrique selon la revendication 10, **caractérisé en ce que** le signal sinusoïdal de basse fréquence présente une fréquence comprise entre 10 Hz et 20 Hz.

12. Commutateur (1) électrique selon la revendication 9 ou 10, **caractérisé en ce que** le signal sinusoïdal est envoyé par salves régulières.

## Claims

1. Electric switch (1) of the type having detection of actuation resulting from contact by the user, without there being displacement of any mechanical part of the said switch, which includes means for generating feedback of tactile order indicating to the said user that detection has been effected and switching performed, the means for generating feedback of tactile order, when detection has been effected, causing a pulsed or vibratory movement of a mechanical element in contact with the actuating finger of the user, **characterised by** the fact that the means generating tactile feedback are supplied with an electrical signal, emitted when detection of the contact has been effected, and shaped and/or modulated by an electronic control circuit (5), detection being performed by means of a capacitive detector connected to the electronic control circuit (5).

2. Electric switch (1) as described in claim 1, **characterised by** the fact that the means for generating feedback of tactile order cause the repetitive movement of a mechanical element in contact with the actuating finger.

3. Electric switch (1) as described in claim 1, **characterised by** the fact that the means for generating feedback of tactile order cause the variable movement of a mechanical element in contact with the actuating finger as a function of the duration, amplitude, or force of the initial actuation.

4. Electric switch (1) as described in any one of claims 1 to 3, **characterised by** the fact that the means for generating tactile feedback include an electric motor rotating a weight having a centre of gravity radially eccentric relative to its axis of rotation.

5. Electric switch (1) as described in claim 1, **characterised by** the fact that the means for generating feedback of tactile order cause a vibration in response to detection of the contact performed by the user.

6. Electric switch (1) as described in the preceding claim, **characterised by** the fact that the vibration is obtained by a piezoelectric component (2) mechanical vibration of which is caused by supplying at least one electrode (3) with an electrical signal emitted after detection of the contact of the user.

7. Electric switch (1) as described in the preceding claim, **characterised by** the fact that at least one electrode (3) of the piezoelectric component (2) acts as an antenna for the capacitive detector (4).

8. Electric switch (1) as described in the preceding claim, **characterised by** the fact that the piezoelectric component (2) is switched from an antenna mode to a vibratile mode via a switching organ of relay, multiplexer, or equivalent type.

9. Electric switch (1) as described in one of claims 6 to 8, **characterised by** the fact that the signal supplied to the piezoelectric component (2) is a signal of sinusoidal shape, emitted at a frequency of between 220 Hz and 300 Hz.

10. Electric switch (1) as described in the preceding claim, **characterised by** the fact that the said signal is amplitude modulated by a low frequency sinusoidal signal.

11. Electric switch (1) as described in claim 10, **characterised by** the fact that the low frequency sinusoidal signal has a frequency of between 10 Hz and 20 Hz.

12. Electric switch (1) as described in claim 9 or 10, **characterised by** the fact that the sinusoidal signal is sent in regular bursts.

## Patentansprüche

1. Elektrischer Schalter (1) des Typs mit Erfassung einer Betätigung, die aus einem Kontakt mit dem Anwender resultiert, ohne dass irgendein zu dem Schalter gehörendes mechanisches Organ verlagert wird, mit Mitteln zum Erzeugen einer Informationsrückgabe taktiler Art, die dem Anwender meldet, dass eine Erfassung erfolgt ist und das Schalten vorgenommen wird, wobei die Mittel zum Erzeugen einer Informationsrückgabe taktiler Art dann, wenn die Erfassung erfolgt, eine impuls- oder vibrationsartige Bewegung eines mechanischen Elements, das mit dem betätigenden Finger des Anwenders in Kontakt ist, hervorruft, **dadurch gekennzeichnet, dass** die eine taktile Informationsrückgabe erzeugenden Mittel durch ein elektrisches Signal gespeist werden, das ausgesendet wird, wenn die Erfassung des Kontakts erfolgt, und durch eine elektronische Steuerschaltung (5) geformt und/oder moduliert wird, wobei die Erfassung kraft eines kapazitiven Detektors erfolgt, der mit der elektronischen Steuerschaltung (5) verbunden ist.

2. Elektrischer Schalter (1) nach Anspruch 1, **dadurch gekennzeichnet, dass** die Mittel zum Erzeugen einer Informationsrückgabe taktiler Art die wiederholte Bewegung eines mit dem betätigenden Finger in Kontakt befindlichen mechanischen Elements hervorrufen.

3. Elektrischer Schalter (1) nach Anspruch 1, **dadurch gekennzeichnet, dass** die Mittel zum Erzeugen einer Informationsrückgabe taktiler Art die veränderliche Bewegung eines mit dem betätigenden Finger in Kontakt befindlichen mechanischen Elements in Abhängigkeit von der Dauer, der Amplitude oder der Kraft der anfänglichen Betätigung hervorrufen.

4. Elektrischer Schalter (1) nach einem der Ansprüche 1 bis 3, **dadurch gekennzeichnet, dass** die Mittel zum Erzeugen einer taktilen Informationsrückgabe einen Elektromotor enthalten, der eine Drehung eines Fliehgewichts hervorruft, dessen Schwerpunkt in Bezug auf seine Drehachse radial exzentrisch ist.

5. Elektrischer Schalter (1) nach Anspruch 1, **dadurch gekennzeichnet, dass** die Mittel zum Erzeugen einer Informationsrückgabe taktiler Art in Reaktion auf die Erfassung des durch den Anwender hergestellten Kontakts eine Vibration hervorrufen.

6. Elektrischer Schalter (1) nach dem vorhergehenden Anspruch, **dadurch gekennzeichnet, dass** die Vibration durch eine piezoelektrische Komponente (2) erhalten wird, deren mechanische Vibration durch Speisung wenigstens einer Elektrode (3) mit einem elektrischen Signal, das nach der Erfassung des Kontakts mit dem Anwender ausgesendet wird, hervorgerufen wird.

7. Elektrischer Schalter (1) nach dem vorhergehenden Anspruch, **dadurch gekennzeichnet, dass** wenigstens eine Elektrode (3) der piezoelektrischen Komponente (2) als Antenne für den kapazitiven Detektor (4) dient.

8. Elektrischer Schalter (1) nach dem vorhergehenden Anspruch, **dadurch gekennzeichnet, dass** die piezoelektrische Komponente (2) über ein Schaltorgan des Typs Relais, Multiplexer oder dergleichen von einer Antennen-Betriebsart in eine Schwingungsbetriebsart umgeschaltet wird.

9. Elektrischer Schalter (1) nach einem der Ansprüche 6 bis 8, **dadurch gekennzeichnet, dass** das Speisesignal der piezoelektrischen Komponente (2) ein Signal mit sinusförmigem Verlauf ist, das mit einer Frequenz ausgesendet wird, die im Bereich von 220 Hz bis 300 Hz liegt.

10. Elektrischer Schalter (1) nach dem vorhergehenden Anspruch, **dadurch gekennzeichnet, dass** das Signal durch ein niederfrequentes sinusförmiges Signal amplitudenmoduliert wird.

11. Elektrischer Schalter (1) nach Anspruch 10, **dadurch gekennzeichnet, dass** das niederfrequente sinusförmige Signal eine Frequenz im Bereich von 10 Hz bis 20 Hz aufweist.

12. Elektrischer Schalter (1) nach Anspruch 9 oder 10, **dadurch gekennzeichnet, dass** das sinusförmige Signal in regelmäßigen Salven geschickt wird.
